# EUROPÄISCHE PATENTANMELDUNG

(11) **EP 2 701 475 A1**
(43) Veröffentlichungstag der Anmeldung: **26.02.2014**
(21) Anmeldenummer: 12181373.7
(22) Anmeldetag: 22.08.2012
(51) Int. Cl.: H05K 5/02, H05K 7/20, G06F 1/16, G06F 1/20, H04N 5/64

(54) **Gehäuse zur Aufnahme eines Flachbildschirms**

(71) Anmelder: Ruf Telematik AG, 8952 Schlieren (CH)
(72) Erfinder: Brunner, Stefan, 5702 Niederlenz (CH); Kern, Thomas, 8620 Wetzikon (CH); Engler, Fred, 8953 Dietikon (CH)
(74) Vertreter: Rutz, Andrea

(57) **Zusammenfassung**

Es wird ein Gehäuse zur Aufnahme eines Flachbildschirms angegeben, mit einem Rahmen (1), welcher einen Gehäuseinnenraum (8) zur Aufnahme des Flachbildschirms begrenzt. Der Rahmen (1) ist aus einem Flachprofilelement hergestellt, welches mehrere Sollbiegestellen (15) aufweist, die zur Festlegung der Eckbereiche (19) des Rahmens (1) dienen. Auf seiner Innenseite weist der Rahmen (1) eine Innenrille (18) auf, in welche ein wärmeabführendes Element (7) derart eingesetzt ist, dass es zum Übertragen von Wärme aus dem Gehäuseinnenraum (8) auf den Rahmen (1) dient.

## Beschreibung

### TECHNISCHES GEBIET

Die vorliegende Erfindung betrifft ein Gehäuse zur Aufnahme eines Flachbildschirms, ein Verfahren zur Herstellung eines derartigen Gehäuses sowie eine Vorrichtung, welche ein solches Gehäuse sowie einen darin aufgenommenen Flachbildschirm aufweist. Derartige Gehäuse werden üblicherweise bei der Installation von Flachbildschirmen im öffentlichen Raum und insbesondere in Fahrzeugen als Installations- und Schutzvorrichtung für den Flachbildschirm verwendet.

### STAND DER TECHNIK

Im öffentlichen Raum und insbesondere in Fahrzeugen des öffentlichen Verkehrs werden oft Flachbildschirme montiert, um einem entsprechenden Publikum Informationen zukommen zu lassen, oder um die Leute zu unterhalten. Dazu können LCD-, TFT-, FED- oder LED-Bildschirme, aber auch Plasmabildschirme oder andere Typen von Flachbildschirmen eingesetzt werden. Insbesondere in Bussen, Zügen und Flugzeugen sind heutzutage pro Fahrzeug üblicherweise meist mehrere Flachbildschirme vorgesehen, um den Passagieren beispielsweise aktuelle Fahrpläne, Sicherheitshinweise oder Neuigkeiten aus dem Weltgeschehen anzuzeigen. Um die Flachbildschirme zu befestigen und vor äusserer mechanischer Beschädigung zu schützen, sind diese üblicherweise in einem Gehäuse aufgenommen. Das Gehäuse mit dem darin aufgenommenen Flachbildschirm wird dann an einer geeigneten, für das entsprechende Publikum gut sichtbaren Stelle an oder in einem Gebäude bzw. einem Fahrzeug etc. befestigt.

Ein Gehäuse der eingangs beschriebenen Gattung ist beispielsweise in der US 7,619,881 beschrieben.

Da derartige Gehäuse insbesondere Schutz gegen äussere, vor allem mechanische Einflüsse bieten sollen, sollten sie eine robuste Bauweise aufweisen und derart ausgestaltet sein, dass die darin aufgenommenen Flachbildschirme zu möglichst allen Seiten hin geschützt sind. Im Stand der Technik werden oft Gehäuse verwendet, die aus Guss-Aluminium oder aus gefrästem Aluminium hergestellt sind. Nachteilig sind dabei jedoch das beträchtliche Gewicht sowie die aufwändige und kostspielige Herstellung derartiger gegossener oder gefräster Gehäuse.

Da elektronische Geräte im Allgemeinen und Flachbildschirme im Speziellen, hauptsächlich aufgrund von ihrer Hinterleuchtung, während ihrem Betrieb Wärme produzieren, stellt die Wärmeabführung nach aussen hin ein weiteres wichtiges Anforderungskriterium für derartige Gehäuse zur Aufnahme eines Flachbildschirms dar. In den Dokumenten US 7,876,553, US 2012/0075802 und US 7,259,964 sind Gehäuse für Flachbildschirme offenbart, welche jeweils eine besondere Vorkehrung zur Abführung der durch die Hinterleuchtung des Flachbildschirms entstehenden Wärme aufweisen. Hierbei kommen in der Regel am Gehäuse angebrachte Rippenstrukturen zum Einsatz, welche zum Abführen der Wärme nach aussen hin dienen.

In vielen Fällen ist die Wärmeabfuhr jedoch trotz allen dafür vorgesehenen Vorkehrungen ungenügend, und es entsteht ein Wärmestau im Inneren des Gehäuses.

Die meisten Gehäuse des Standes der Technik weisen eine verhältnismässig aufwändige und entsprechend kostspielige Bauweise auf. Die Gehäuse sind meist für bestimmte Typen und Grössen von Flachbildschirmen ausgelegt, und der Herstellungsprozess dieser Gehäuse kann nur mit einem verhältnismässigen beträchtlichen Aufwand an anders ausgestaltete Flachbildschirme angepasst werden. Ausserdem ist bei Gehäusen des Standes der Technik der direkte Kontakt der wärmeabführenden Strukturen mit dem Flachbildschirm aufgrund von fertigungstechnischen Toleranzen nicht immer gewährleistet. Es besteht dadurch das Problem, dass die insbesondere im Bereich der Hinterleuchtung im Flachbildschirm entstehende Wärme nicht ausreichend nach aussen hin abgeführt werden kann. Im Extremfall kann dies zu einer irreversiblen Beschädigung des Flachbildschirms führen.

### DARSTELLUNG DER ERFINDUNG

Es ist also eine Aufgabe der vorliegenden Erfindung, ein Gehäuse zur Aufnahme eines Flachbildschirms anzugeben, dessen Herstellung nicht nur verhältnismässig einfach und kostengünstig ist, sondern auch einfach an beliebige Typen und Grössen von Flachbildschirmen anpassbar ist. Zur Lösung dieser Aufgabe wird ein Gehäuse vorgeschlagen, wie es in Anspruch 1 angegeben ist. Ausserdem wird in Anspruch 12 ein Verfahren zur Herstellung eines derartigen Gehäuses angegeben.

Eine weitere Aufgabe der vorliegenden Erfindung besteht darin, ein Gehäuse zur Aufnahme eines Flachbildschirms bereitzustellen, bei dem das Abführen der im Flachbildschirm entstehenden Wärme nach aussen hin jederzeit in ausreichendem Masse gewährleistet ist. Zur Lösung dieser Aufgabe wird ein Gehäuse vorgeschlagen, wie es in Anspruch 9 angegeben ist.

In Anspruch 15 wird zudem eine Vorrichtung angegeben, welche ein Gehäuse sowie einen darin aufgenommenen Flachbildschirm aufweist. Vorteilhafte Ausgestaltungen der Erfindung sind in den abhängigen Ansprüchen angegeben.

Die vorliegende Erfindung stellt also ein Gehäuse zur Aufnahme eines Flachbildschirms zur Verfügung, mit einem Rahmen, welcher einen Gehäuseinnenraum zur Aufnahme des Flachbildschirms begrenzt. Der Rahmen ist aus einem insbesondere stranggepressten Flachprofilelement hergestellt, welches mehrere Sollbiegestellen aufweist, die zur Festlegung der Eckbereiche des Rahmens dienen.

In der Regel umschliesst der Rahmen des Gehäuses den Gehäuseinnenraum seitlich, das heisst zu derjenigen Seite des im Gehäuse aufgenommenen Flachbildschirms hin, welche sich senkrecht zur Anzeigefläche des Bildschirms erstreckt. Dadurch, dass der Rahmen aus einem Flachprofilelement mit entsprechend vorgesehenen Sollbiegestellen hergestellt ist, sind der Rahmen und somit das Gehäuse äusserst einfach und kostengünstig herstellbar und insbesondere bei der Herstellung sehr einfach an beliebige Typen und Grössen von Flachbildschirmen anpassbar. Das in der Regel einstückige Flachprofilelement ist bevorzugt aus einem Metall, und insbesondere bevorzugt aus Aluminium, hergestellt. Das Gewicht des Gehäuses ist dadurch um ca. 40 % geringer im Vergleich zu einem entsprechenden aus Guss-Aluminium hergestellten Gehäuse. Ausserdem ist die Wärmeleitfähigkeit von Aluminiumprofilen und insbesondere von stranggepressten Aluminiumprofilen erheblich besser wie von Guss-Aluminium.

Beim Flachbildschirm kann es sich insbesondere um einen LCD-, TFT-, FED- oder LED-Bildschirm oder auch um einen Plasmabildschirm handeln. Je nach Ausgestaltung kann der Flachbildschirm insbesondere auch als ein Anzeigepanel, ein Display oder ein Monitor bezeichnet werden. Grundsätzlich weist der Flachbildschirm im Vergleich zu seinen übrigen Abmessungen eine verhältnismässig wesentlich geringere Dicke auf, gemessen in eine senkrecht zur Anzeigefläche stehende Richtung.

Üblicherweise wird ein Flachprofilelement gewählt, dessen Breite ungefähr gleich gross oder geringfügig grösser als die Dicke des im Gehäuse aufzunehmenden Flachbildschirms ist. Unter der Dicke des Flachbildschirms ist hierbei und im Folgenden jeweils diejenige Dimension gemeint, welche senkrecht zur Anzeigefläche des Bildschirms erstreckt.

Bei der Herstellung des Rahmens wird in der Regel in einem ersten Schritt das Flachprofilelement hinsichtlich seiner Länge an die Umfangslänge des Flachbildschirms angepasst, so dass sich später bevorzugt ein Rahmen ergibt, welcher derart ausgebildet ist, dass er den Flachbildschirm seitlich zu einem grossen Teil, insbesondere bevorzugt im Wesentlichen vollständig, umgibt. Die Länge des Flachprofilelements entspricht somit bevorzugt ungefähr der Umfangslänge des Flachbildschirms. In einem zweiten Schritt werden dann in der Regel entlang der Längsrichtung des Flachprofilelements mehrere, insbesondere genau drei oder genau vier, Sollbiegestellen vorgesehen, um die Positionen der Eckbereiche des späteren Rahmens festzulegen. Die Abstände der verschiedenen Sollbiegestellen zueinander entlang der Längsrichtung des Flachprofilelements entsprechen dabei vorteilhaft ungefähr den Seitenlängen des Flachbildschirms. In einem dritten Schritt kann das Flachprofilelement dann in den Bereichen der Sollbiegestellen bevorzugt um jeweils mehr als 80° und weniger als 100°, insbesondere um ungefähr 90°, gebogen werden, sodass ein vorteilhaft rechteckiger, zur Aufnahme des Flachbildschirms geeigneter Rahmen entsteht. Selbstverständlich können bei der Herstellung des Rahmens weitere Schritte vorgenommen werden. So können am Flachprofilelement insbesondere Bohrungen, Aussparungen und Nuten vorgesehen werden.

Orts- und Richtungsangaben wie oben, unten, vorne, hinten, oberhalb, unterhalb, nach innen und nach aussen beziehen sich im Folgenden jeweils auf ein in bestimmungsgemässer Weise, zum Beispiel an bzw. in einem Fahrzeug oder an bzw. in einem Gebäude montiertes Gehäuse mit einem darin aufgenommen Flachbildschirm, bei welchem die Anzeigefläche nach vorne hin gewandt ist und sich ungefähr parallel zur Schwerkraftrichtung erstreckt, so dass ein aufrecht stehender Beobachter eine optimale Sicht auf den auf Augenhöhe angeordneten Flachbildschirm hat.

Bevorzugt sind die Sollbiegestellen jeweils durch eine Materialverdünnung an der entsprechenden Stelle definiert. Die Materialverdünnung kann auf eine beliebige Art und Weise, wie insbesondere mittels eines spanabhebenden Prozesses, also zum Beispiel einer Einfräsung, hergestellt sein und erstreckt sich vorteilhaft, aber nicht zwingend, im Wesentlichen über die gesamte Breite des Flachprofilelements und dabei insbesondere im Wesentlichen in eine relativ zur Längsrichtung senkrecht stehende Richtung. Im Falle, dass die Sollbiegestellen jeweils durch eine Materialverdünnung definiert sind, kann das Biegen des Flachprofilelements zu einem Rahmen auf eine besonders einfache und präzise Art und Weise, mit einem verhältnismässig geringen Kraftaufwand erfolgen. Vorteilhaft sind die Materialverdünnungen jeweils in Form von Vertiefungen auf derjenigen Seite des Flachprofilelements vorgesehen, welche beim fertig hergestellten Rahmen die zum Gehäuseinnenraum hin gewandte Seite bildet.

Falls die Sollbiegestellen durch Materialverdünnungen definiert sind, ist das Flachprofilelement an den entsprechenden Stellen jeweils bevorzugt um zumindest die Hälfte, noch bevorzugter um zumindest zwei Drittel, und am meisten bevorzugt um zumindest drei Viertel der Materialdicke verdünnt.

Die Materialverdünnungen sind bevorzugt jeweils durch eine Nut gebildet, welche eine beliebige Form aufweisen kann. So kann die Nut beispielsweise insbesondere V-förmig oder U-förmig ausgestaltet sein. Bevorzugt ist die Nut jedoch als eine Mischform einer V-förmigen und einer U-förmigen Nut ausgestaltet. Eine Nut gemäss einer derartigen Mischform ist von zwei planen Flächen und einer dazwischen angeordneten, gebogenen Fläche begrenzt. Eine derartig ausgestaltete Nut bildet eine klar definierte Sollbiegestelle, welche ein einfaches und präzises Biegen des Flachprofilelements an der entsprechenden Stelle erlaubt. Die Biegung erfolgt dann insbesondere im Bereich der gebogenen Fläche der Nut. Bevorzugt beträgt der Radius der gebogenen Fläche mindestens einen Zwölftel, noch bevorzugter mindestens einen Zehntel, und am meisten bevorzugt mindestens einen Achtel der Dicke des Flachprofilelements.

Vorteilhaft schliessen die beiden planen Flächen der Nut einen Winkel von mehr als 60° und von weniger als 120°, insbesondere von mehr als 80° und weniger als 100°, ein. Am vorteilhaftesten schliessen sie aber einen Winkel von ungefähr 90° ein. Im fertigen Rahmen erstrecken sich die beiden planen Flächen der Nut dann bevorzugt im Wesentlichen parallel zueinander und liegen insbesondere bevorzugt aneinander an.

Der Rahmen bildet vorzugsweise ein im Wesentlichen geschlossenes Rechteck, dessen Seitenlängen vorteilhaft ungefähr in einem Verhältnis von 4:3, 15:9, 16:9 oder 16:10 zueinander stehen. Dabei kann der Rahmen insbesondere eine Verbindungsstelle aufweisen, bei welcher die beiden Enden des Flachprofilelements miteinander verbunden sind. Vorteilhaft ist der Rahmen also derart ausgebildet, dass er einen im Gehäuse aufgenommenen Flachbildschirm seitlich in Umfangsrichtung im Wesentlichen vollständig umschliesst. Im Bereich der Verbindungsstelle kann insbesondere eine Verbindungsplatte vorgesehen sein, mittels welcher die beiden Enden des Flachprofilelements miteinander verbunden sind. Diese Verbindungsplatte ist vorzugsweise auf der Aussenseite des Rahmens befestigt. Die beiden Endflächen des Flachprofilelements in Längsrichtung können aneinander anliegen, müssen es aber nicht. Vorzugsweise sind sie aber in unmittelbarer Nähe zueinander angeordnet. Bevorzugt ist die Verbindungsstelle beabstandet zu den Eckbereichen des Rahmens und insbesondere bevorzugt innerhalb einer der Längsseiten des Rahmens , am meisten bevorzugt innerhalb der unteren Längsseite des Rahmens, angeordnet. Dabei ist die Verbindungsstelle jedoch vorteilhaft in der Nähe von einem der Eckbereiche des Rahmens angeordnet. Alternativ kann die Verbindungsstelle aber insbesondere auch einen der Eckbereiche des Rahmens bilden.

Vorzugsweise weist der Rahmen eine Aussparung auf, welche zur Aufnahme eines Elektronikbauteils dient, und welche insbesondere im Bereich der Verbindungsstelle angeordnet ist. Bevorzugt ist diese Aussparung seitlich vollständig vom Material des Rahmens umgeben. In einer bevorzugten Ausführungsform begrenzen die beiden Enden des Flachprofilelements die Aussparung gemeinsam. Bei einer derartigen Ausführungsform weisen beide Enden des Flachprofilelements vorteilhaft jeweils eine in Längsrichtung des Flachprofilelements nach aussen hin offene Aussparung auf. Beim Elektronikbauteil kann es sich insbesondere um eine Printplatte handeln, welche Anzeigeelemente, wie LED's sowie Sensoren aufweisen kann, die zum Beispiel zur Anzeige des Betriebszustandes des Flachbildschirms sowie zur Messung der Helligkeitsverhältnisse in der Umgebung dienen. Um einen Sichtkontakt von den LED's bzw. den Sensoren der Printplatte nach vorne, zum Betrachter hin herzustellen, kann der Rahmen entsprechend angeordnete Bohrungen aufweisen, welche sich von einer die Aussparung begrenzenden Innenflächen bis zu einer nach vorne hin gewandten Oberfläche des Rahmens hin erstrecken.

Falls eine Aussparung im Rahmen vorhanden ist, können am Rahmen im Bereich der Aussparung zudem Einkerbungen vorgesehen sein, welche zur Halterung der Printplatte in der Aussparung dienen. Entsprechend ausgebildete, seitlich abstehende Vorsprünge der Printplatte, welche insbesondere jeweils die Form eines Stiftes haben, können dann in die Einkerbungen eingelegt werden, um die Printplatte in der Aussparung zu halten. Die Einkerbungen können dabei insbesondere zur Aussparung hin und bevorzugt auch zu derjenigen Seite, auf welcher eine Verbindungsplatte am Rahmen angebracht wird, offen ausgebildet sein. Durch das Anbringen der Verbindungsplatte am Rahmen werden die Einkerbungen dann bevorzugt zu der entsprechenden Seite hin verschlossen, so dass eine mit ihren seitlichen Vorsprüngen in die Einkerbungen eingelegte Printplatte im Gehäuse gehalten ist.

Üblicherweise weist das Gehäuse eine Rückwand auf, welche zum Verschliessen des vom Rahmen seitlich begrenzten Gehäuseinnenraums auf der Rückseite dient. Bevorzugt ist an der Rückwand zumindest eine Verbindungslasche angebracht, die zur Befestigung der Rückwand am Rahmen dient. In einer bevorzugten Ausführungsform sind die eine bzw. die mehreren Verbindungslaschen im Wesentlichen entlang des gesamten Umfangs vorteilhaft derart an der Rückwand angebracht, dass sie im Wesentlichen senkrecht von dieser abstehen. Bevorzugt ist die Rückwand gemeinsam mit den daran angebrachten Verbindungslaschen einstückig aus einem Metallblech, insbesondere einem Aluminiumblech, hergestellt. Die Verbindung der Verbindungslaschen mit dem Rahmen kann insbesondere mittels Schrauben erfolgen, welche vor dem Anziehen vorteilhaft in entsprechenden, dafür vorgesehenen Verbindungsbohrungen des Rahmens ein gewisses Spiel haben. Das Auseinandernehmen und Wiederzusammensetzen des Gehäuses zum Beispiel zur Reparatur kann dann auf einfache Art und Weise erfolgen, und es kann sichergestellt werden, dass die Rückwand jederzeit an der Rückseite des im Gehäuse aufgenommenen Flachbildschirms anliegt.

Die vorliegende Erfindung stellt ausserdem ein Gehäuse zur Verfügung, welches wie oben ausgeführt ausgebildet sein kann, zur Aufnahme eines Flachbildschirms dient und einen Rahmen aufweist, welcher einen Gehäuseinnenraum zur Aufnahme des Flachbildschirms begrenzt, sowie zumindest ein wärmeabführendes Element aufweist, welches an der Innenseite des Rahmens angebracht ist, und welches zum Übertragen von Wärme, die im Gehäuseinnenraum entsteht, auf den Rahmen dient. Der Rahmen weist dabei auf seiner zum Gehäuseinnenraum hin gewandten Seite eine Innenrille auf, in welche das wärmeabführende Element eingesetzt ist.

Bei einer derartigen Ausbildung des Gehäuses kann der darin aufgenommene Flachbildschirm insbesondere zwischen dem wärmeabführenden Element und zum Beispiel einer Rückwand des Gehäuses eingeklemmt sein. Auf diese Weise kann sichergestellt werden, dass der Flachbildschirm jederzeit mit dem wärmeabführenden Element in Kontakt steht, wodurch das Abführen der im Flachbildschirm entstehenden Wärme gewährleistet ist.

Es hat sich gezeigt, dass oft verkannt wird, dass das Hauptproblem der Wärmeabfuhr der Transport der Wärme inwendig vom Flachbildschirm zum Gehäuse und nicht vom Gehäuse an die Umgebung ist. Das Anbringen von aufwendigen Verrippungen auf der Aussenseite des Gehäuses führt in diesen Fällen meist nicht zu einer wesentlichen Verbesserung der Wärmeabfuhr, da meistens die Oberfläche des Gehäuses bereits genug gross ist, um auch ohne Verrippung die Wärme an die Umgebung abzugeben. Mit der vorliegenden Erfindung kann aber die Wärmeübertragung vom Flachbildschirm auf das Gehäuse jederzeit sichergestellt und somit ein Wärmestau verhindert werden.

Beim wärmeabführenden Element kann es sich um ein beliebiges, vom Rahmen in den Gehäuseinnenraum hineinragendes Element handeln, welches bevorzugt aus einem Metall, insbesondere Aluminium, hergestellt ist. Bevorzugt ist das wärmeabführende Element jedoch als eine Leiste ausgebildet, welche entlang einer ihrer Längsseiten in die Innenrille eingesetzt ist. Das wärmeabführende Element kann mittels Presssitz in der Innenrille befestigt sein und/oder mittels eines Klebstoffs oder eines anderen Befestigungsmittels, wie zum Beispiel Schrauben, in der Innenrille fixiert sein.

In einer bevorzugten Ausführungsform erstrecken sich die Innenrille und insbesondere auch das wärmeabführende Element entlang des gesamten Umfangs des durch den Rahmen begrenzten Gehäuseinnenraums. Das wärmeabführende Element kann sich aber auch nur über einen Teil des Umfangs erstrecken und insbesondere nur entlang einer oberen Längsseite des Rahmens vorgesehen sein.

In einer bevorzugten Ausführungsform weist das Gehäuse zudem eine Frontscheibe auf, welche am wärmeabführenden Element und insbesondere an dessen nach vorne hin gewandten Seite angeklebt sein kann. Das wärmeabführende Element ist dann also vorteilhaft zwischen dem Flachbildschirm und der Frontscheibe, welche in der Regel dazu dient, die Anzeigefläche des Flachbildschirms zu schützen, angeordnet. Das Gehäuse kann ausserdem eine Frontblende aufweisen, welche bevorzugt an den Rahmen anschraubbar ist und vorteilhaft derart ausgestaltet ist, dass sie das wärmeabführende Element nach vorne zum Betrachter hin vollständig überdeckt.

Ein Gehäuse, welches gemäss den obenstehenden Ausführungen ausgebildet ist, ist insgesamt sehr einfach und kostengünstig herstellbar, und die Abführung der im Gehäuse entstehenden Wärme kann jederzeit auf einfache Art und Weise gewährleistet werden.

### KURZE BESCHREIBUNG DER ZEICHNUNGEN

Bevorzugte Ausführungsformen der Erfindung werden im Folgenden anhand der Zeichnungen beschrieben, die lediglich zur Erläuterung dienen und nicht einschränkend auszulegen sind. In den Zeichnungen zeigen:
- Fig. 1: eine perspektivische Ansicht von vorne eines Gehäuses gemäss einer bevorzugten, erfindungsgemässen Ausführungsform, zur Aufnahme eines Flachbildschirms;
- Fig. 2: eine perspektivische Ansicht des Gehäuses der Figur 1 von hinten;
- Fig. 3: eine perspektivische Ansicht des Rahmens des Gehäuses der Figur 1 von vorne;
- Fig. 4: eine perspektivische Teilansicht des Rahmens der Figur 3 von vorne;
- Fig. 5: eine frontale Teilansicht des Rahmens des Gehäuses der Figur 1 von hinten, mit daran angebrachter Verbindungsplatte;
- Fig. 6: eine stark vergrösserte, frontale Teilansicht von hinten des Flachprofilelements, welches zur Herstellung des Rahmens des Gehäuses der Figur 1 dient.
- Fig. 7: eine perspektivische Ansicht von vorne des Rahmens des Gehäuses der Figur 1, mit daran angebrachter Verbindungsplatte;
- Fig.8: eine perspektivische Teilansicht des Rahmens des Gehäuses der Figur 1 von innen, mit daran angebrachter Verbindungsplatte;
- Fig. 9: eine perspektivische Ansicht des Rahmens des Gehäuses der Figur 1 von vorne, mit daran angebrachten wärmeabführenden Leisten;
- Fig. 10: eine Schnittansicht des Gehäuses der Figur 1 in der in der Figur 2 gekennzeichneten Ebene X-X;
- Fig. 11: eine vergrösserte Detailansicht des in der Figur 10 markierten Bereiches; sowie
- Fig. 12: eine Schnittansicht des Gehäuses der Figur 1 in der in der Figur 2 gekennzeichneten Ebene XII-XII.

### BESCHREIBUNG BEVORZUGTER AUSFÜHRUNGSFORMEN

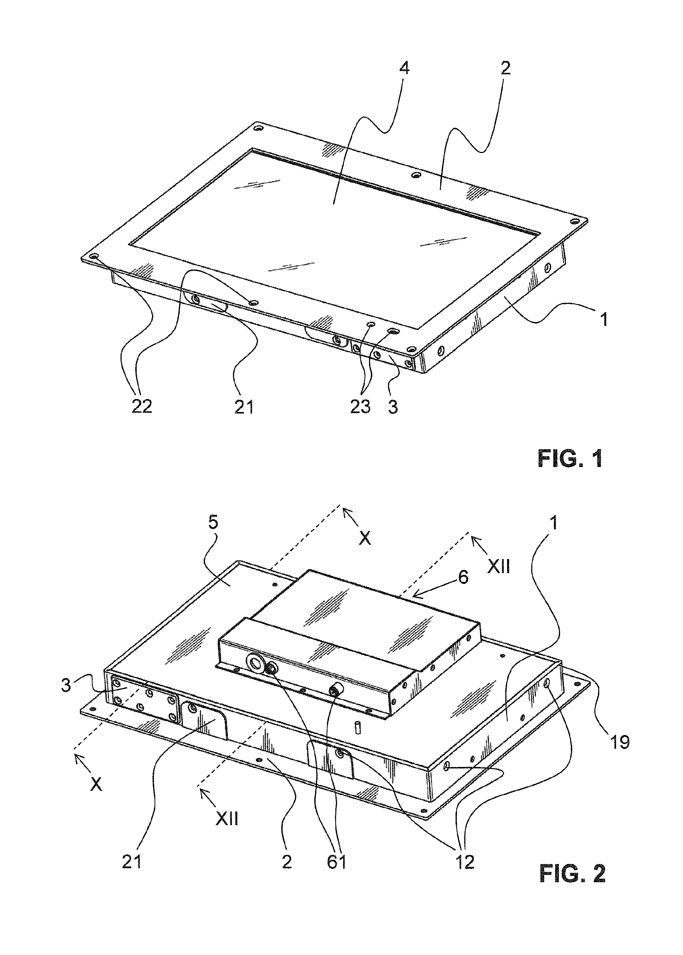

In den Figuren 1 und 2 ist ein Gehäuse gemäss einer ersten erfindungsgemässen Ausführungsform, zur Aufnahme eines Flachbildschirms dargestellt. Das Gehäuse weist einen Gehäuseinnenraum 8 auf, welcher zur Aufnahme eines Flachbildschirms geeignet ist, und welcher im Wesentlichen seitlich durch einen Rahmen 1, nach vorne durch eine Frontscheibe 4 sowie nach hinten durch eine Rückwand 5 begrenzt ist.

Im Bereich der Vorderseite des Gehäuses ist am Rahmen 1 eine Frontblende 2 angebracht, welche eine grosse, rechteckige Öffnung aufweist, durch welche hindurch die Anzeigefläche bzw. das Display des im Gehäuse aufgenommenen Bildschirms einsehbar ist. Zur Verbindung mit dem Rahmen 1 sind auf der Rückseite der Frontblende 2 mehrere Verbindungslaschen 21 angebracht, welche im zusammengebauten Zustand des Gehäuses auf der Aussenseite des Rahmens 1 anliegen. Die Verbindungslaschen 21 weisen jeweils Bohrungen auf, welche mit Verbindungsbohrungen 12 des Rahmens 1 korrespondieren, um Schraubverbindungen zwischen der Frontblende 2 und dem Rahmen 1 zu ermöglichen.

In einem Bereich der Frontblende 2, welcher sich im Wesentlichen parallel zur Frontscheibe 4 und somit zur Sichtseite eines im Gehäuse aufgenommenen Flachbildschirms erstreckt, und welcher zudem den Rahmen 1 seitlich nach aussen hin übersteht, sind mehrere Bohrungen 22 vorgesehen, welche zur Befestigung der Frontblende 2 zum Beispiel an oder in einem Fahrzeug oder Gebäude dienen.

Die Frontblende 2 weist zudem Aussparungen 23 auf, welche für den Benutzer die Sicht auf eine dahinter angeordnete LED-Anzeige ermöglichen. Die LED-Anzeige, deren Anordnung im Gehäuse weiter unten noch genauer erklärt wird, kann beispielsweise zur Anzeige des Betriebszustandes oder dem Anliegen einer Netzspannung am Flachbildschirm dienen. Hinter den Aussparungen 23 können aber auch Sensoren angeordnet sein, welche beispielsweise zur Messung der Umgebungshelligkeit dienen können.

Auf der Aussenseite der Rückwand 5 ist im vorliegenden Ausführungsbeispiel ein Steuerschaltungsmodul 6 angebracht, welches in Bezug auf das Gehäuse für den Flachbildschirm ein separates Gehäuse aufweist, das zum Beispiel zur Aufnahme eines Steuer-Schaltkreises zur Steuerung des Flachbildschirms dient. Im Bereich ihrer beiden aufeinanderliegenden Flächen weisen die Rückwand 5 und das Steuerschaltungsmodul 6 jeweils zumindest eine korrespondierende Aussparung auf, welche zum Durchführen von Kabelsträngen bzw. Steuerleitungen dient. Das Steuerschaltungsmodul 6 weist auf seiner Aussenseite Anschlüsse 61 auf, um das Steuerschaltungsmodul 6 beispielsweise mit einer Netzspannung zu versorgen oder an einem Datenkommunikationskabel anzuschliessen. Dadurch, dass die elektronischen Komponenten zur Steuerung des Flachbildschirms in einem separaten Gehäuse des Steuerschaltungsmoduls 6 untergebracht sind, sind die Lufträume, was die Wärmeentwicklung des Flachbildschirms bzw. der elektronischen Steuerung angeht, im Wesentlichen vollständig voneinander getrennt, so dass die jeweils entstehende Wärme unabhängig voneinander abgeführt werden kann.

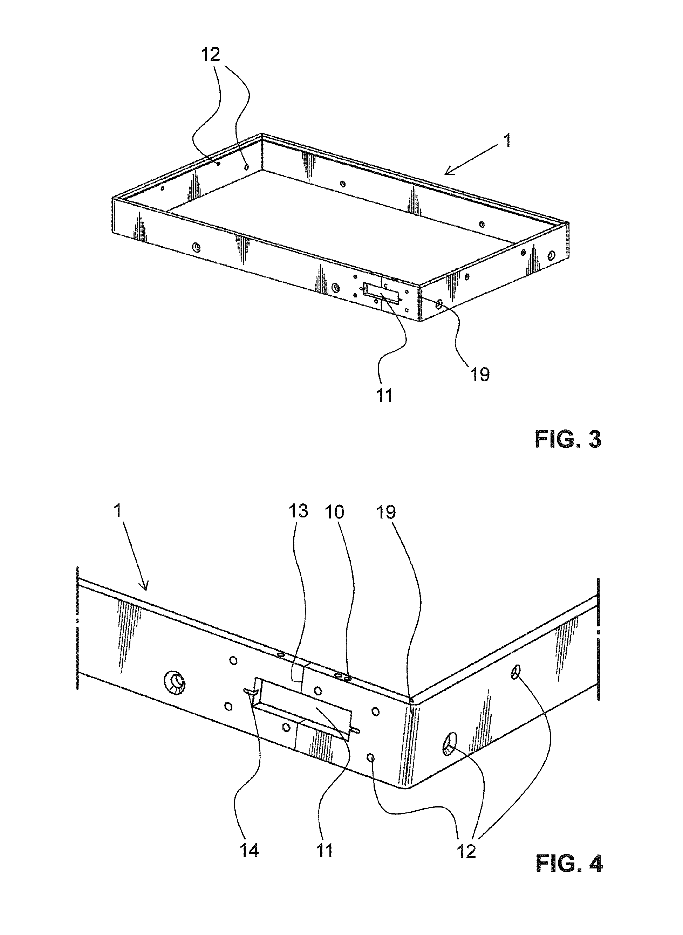

Die Ausgestaltung des Rahmens 1 ist insbesondere in den Figuren 3 bis 6 gut erkennbar. Der Rahmen 1 ist aus einem einfachen Flachprofilelement hergestellt, welches seinerseits durch einfaches Strangpressen eines Metalls, wie insbesondere Aluminium, hergestellt werden kann. Die Länge des verwendeten Flachprofilelements wird dabei derart gewählt, dass sie geringfügig länger ist, als der seitliche Umfang des einzufassenden Flachbildschirms. Zur Herstellung des Rahmens 1 werden mehrere Sollbiegestellen in das Flachprofilelement eingefräst, welche zur Festlegung der Eckbereiche 19 des Rahmens 1 dienen.

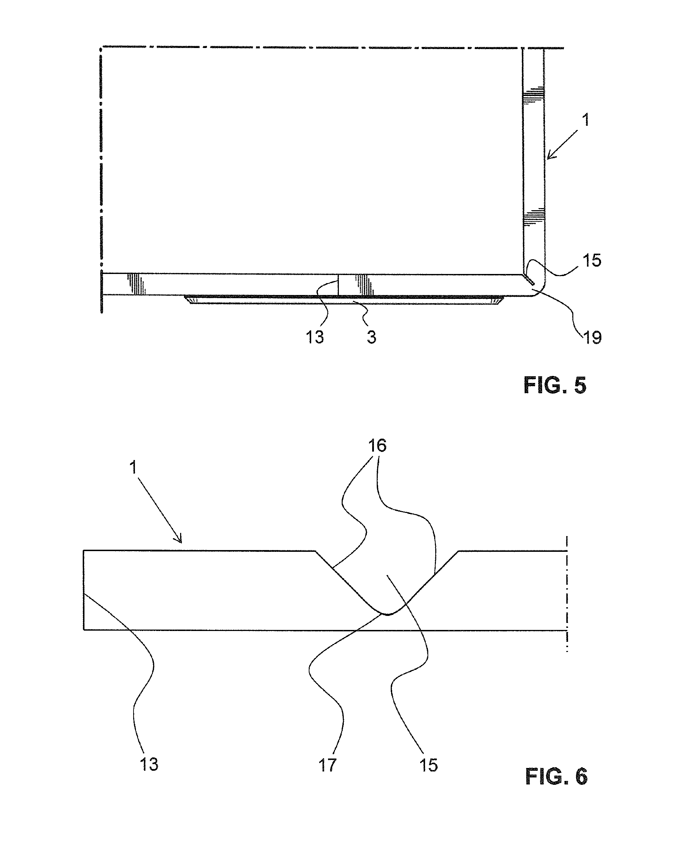

Die Sollbiegestellen sind dabei jeweils als Nuten 15 ausgebildet, welche sich im Wesentlichen senkrecht zur Längsrichtung des Flachprofilelements über dessen gesamte Breite erstrecken. Im vorliegenden Fall sind genau vier Nuten 15 vorgesehen. Die Tiefe der Nuten 15 beträgt dabei jeweils etwa zwei Drittel bis etwa drei Viertel der Dicke des Flachprofilelements. Mittels eines Kegelfräsers werden die Nuten 15 derart in das Flachprofilelement eingefräst, dass sie, wie aus der Figur 6 ersichtlich ist, von zwei planen Flächen 16 sowie einer dazwischen liegenden, gebogenen Fläche 17 begrenzt sind. Die planen Flächen 16 schliessen dabei einen Winkel von ungefähr 90° ein.

Durch das Vorsehen der Nuten 15 kann das Flachprofilelement anschliessend mit geringem Kraftaufwand und auf eine präzise Art und Weise in die in Figur 3 gezeigte, rechteckige Form des Rahmens 1 mit wohldefinierten Eckbereichen 19 gebracht werden.

Nach dem Biegen des Flachprofilelements zum Rahmen 1 erstrecken sich die planen Flächen 16 der Nuten 15 jeweils parallel zueinander, und im Wesentlichen parallel zu der durch den jeweiligen Eckbereich 19 vorgegebenen Winkelhalbierenden (siehe Figur 5).

Am Rahmen 1 sind ausserdem eine Vielzahl von Verbindungsbohrungen 12 ausgebildet, welche insbesondere das Herstellen von Schraubverbindungen mit der Frontblende 2, der Rückwand 5 sowie der weiter unten erläuterten Verbindungsplatte 3 erlauben. Die Verbindungsbohrungen 12 können jeweils mit einem Innengewinde versehen sein. Die Verbindungen können aber auch mittels Schraube und Mutter erstellt werden. Alternativ können die Verbindungen der genannten Bauteile aber zum Beispiel auch als Kleb- oder Nietverbindungen ausgebildet sein.

Das zur Herstellung des Rahmens 1 verwendete Flachprofilelement weist in Längsrichtung zwei Enden auf, welche im vorliegenden Ausführungsbeispiel nach der Formung des Rahmens 1 unmittelbar nebeneinander angeordnet sind oder sogar aneinander anliegen, um eine Verbindungsstelle 13 zu bilden. Diese Verbindungstelle 13 wird, wie es in den Figuren 5, 7 und 8 gezeigt ist, mittels einer Verbindungsplatte 3 verbunden. Diese Verbindungsplatte 3 wird derart an der Aussenseite des Rahmens 1 angeschraubt, dass sie fest an beiden Enden des Flachprofilelements angebracht ist. Um die Verbindungsplatte 3 am Rahmen 1 anzuschrauben, weisen die Verbindungsplatte 3 sowie der Rahmen 1 im Bereich der Verbindungsstelle 13 jeweils einander entsprechende Bohrungen 31 bzw. 12 auf.

Im Bereich der Verbindungstelle 13 weist der Rahmen 1 eine Aussparung 11 auf. Diese ist in dem zur Herstellung des Rahmens 1 vorgesehenen Flachprofilelement im Bereich der beiden Enden als jeweils eine nach aussen hin offene Aussparung ausgebildet. Aufgrund der Aussparung 11 weisen die beiden Enden des Flachprofilelements daher jeweils eine im Wesentlichen U-förmige Gestalt auf. Nach dem Verbinden der beiden Enden des Flachprofilelements an der Verbindungsstelle 13 beschreibt die Aussparung 11 eine rechteckige Form, welche von der Verbindungsplatte 3 nach unten hin vollständig überdeckt wird.

Die Aussparung 11 dient zur Aufnahme eines Elektronik-Bauteils, welches insbesondere als Printplatte bzw. gedruckte Leiterplatine ausgebildet sein kann. Im vorliegenden Ausführungsbeispiel dient die Aussparung 11 zu Aufnahme einer mit LEDs und Sensoren bestückten Printplatte. Die LEDs und Sensoren dienen dazu, den Betriebszustand des im Gehäuse aufgenommenen Flachbildschirms anzuzeigen bzw. die Helligkeitsverhältnisse in der Umgebung zu messen. Der Rahmen 1 weist hierfür Sichtbohrungen 10 auf, welche sich von einer Innenfläche der Aussparung 11 bis zu der nach vorne hin gerichteten Fläche des Rahmens 1 erstrecken, und welche sich somit im Wesentlichen parallel zur derjenigen Richtung erstrecken, in welcher ein Betrachter üblicherweise auf die Anzeigefläche eines im Gehäuse aufgenommenen Bildschirms schaut. Die Sichtbohrungen 10 sind jeweils derart angeordnet, dass sie bei am Rahmen 1 angebrachter Frontblende 2 mit den Aussparungen 23 der Frontblende 2 fluchten. Eine Sichtverbindung von aussen zu den LEDs bzw. Sensoren der Printplatte ist somit durch die Sichtbohrungen 10 und die Aussparungen 23 hindurch gewährleistet.

Um das Elektronik-Bauteil bzw. die Printplatte mit den LEDs und Sensoren in der Aussparung 11 zu halten, sind am Rand der Aussparung 11 zwei gegenüberliegende Einkerbungen 14 vorhanden. Die Einkerbungen 14 sind dazu ausgebildet, entsprechend geformte Stifte, die an der Printplatte angebracht sind und seitlich von dieser abstehen, aufzunehmen. Die Einkerbungen 14 sind dazu jeweils zur Aussparung 11 sowie zur Unterseite des Rahmens 1 hin offen ausgebildet. Eine Printplatte kann dadurch auf einfache Art und Weise von unten her in die Aussparung 11 und mit den seitlich abstehenden Stiften in die Einkerbungen 14 eingesetzt werden. Indem die Verbindungsplatte 3 am Rahmen 1 angebracht wird, werden die Einkerbungen 14 nach unten hin verschlossen, so dass die Printplatte mit ihren seitlich abstehenden Stiften in den Einkerbungen 14 gehalten ist.

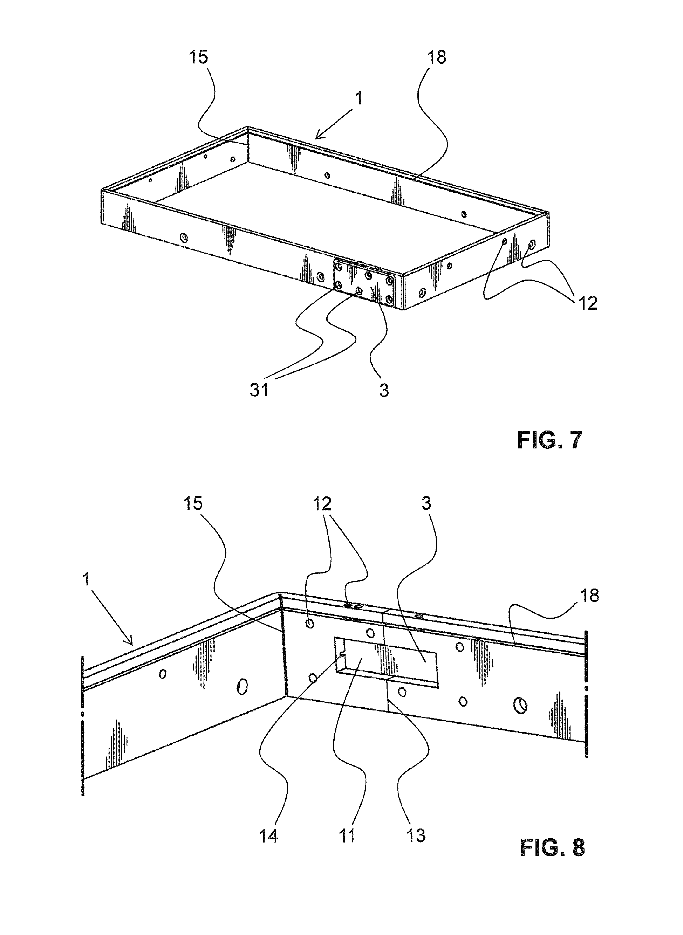

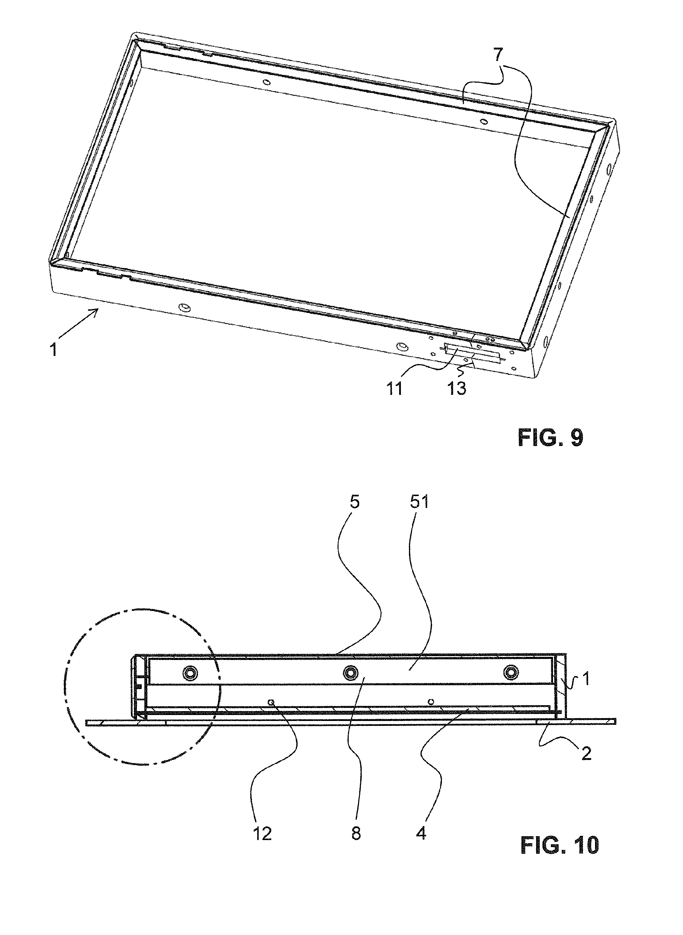

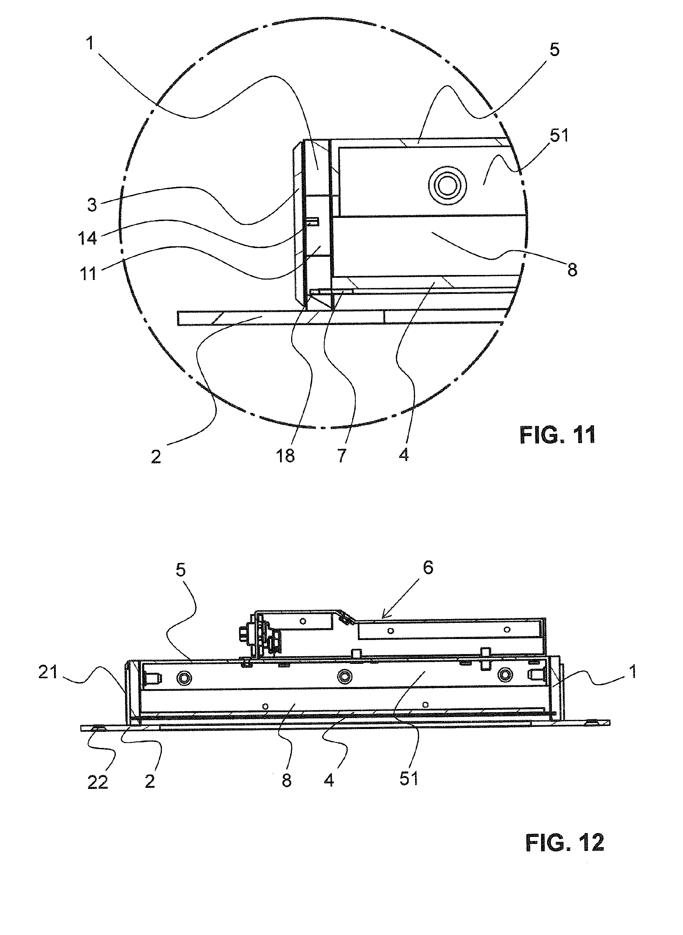

Wie insbesondere in den Figuren 7 und 8 sowie 11 erkennbar ist, ist auf der Innenseite des Rahmens 1 eine umlaufende Innenrille 18 ausgebildet. Diese Innenrille 18 ist in einem vorderen Bereich des Rahmens 1 angeordnet. Bevorzugt wird die Innenrille 18 bereits in das noch nicht zu einem Rahmen 1 geformte Flachprofilelement eingefräst. Die Innenrille 18 erstreckt sich dann parallel zur Längsrichtung des Flachprofilelements und bevorzugt im Wesentlichen über die gesamte Länge des Flachprofilelements. Alternativ kann die Innenrille 18 aber auch erst nach dem Biegen des Flachprofilelements zu einem Rahmen 1 in dessen Innenseite eingefräst werden. Die Innenrille 18 dient zum Einsetzen von wärmeabführenden Leisten 7, welche in den Figuren 9 und 11 gut erkennbar sind. In jeder der vier Seiten des rechteckigen Rahmens 1 ist jeweils eine wärmabführende Leiste 7 in die Innenrille 18 eingesetzt, insbesondere eingepresst. Die wärmeabführenden Leisten 7 sind aus einem gut wärmeleitenden Material, wie insbesondere einem Metallblech, hergestellt. Das Gehäuse ist dabei derart ausgebildet, dass ein im Gehäuse aufgenommener Flachbildschirm mit seinem nach vorne gerichteten Randbereich direkt im Wesentlichen umlaufend an der jeweils nach hinten gerichteten Seite der wärmeabführenden Leisten 7 anliegt. Auf diese Weise kann Wärme, welche insbesondere aufgrund der Hinterleuchtung im Flachbildschirm entsteht, mittels Wärmeleitung über die wärmeabführenden Leisten 7 auf den Rahmen 1 übertragen werden.

Nach dem Einlegen des Flachbildschirms in das Gehäuse von hinten her, wird die Rückseite des Gehäuses mit der Rückwand 5 verschlossen. Die Rückwand 5, welche insbesondere aus einem einfachen Aluminiumblech hergestellt sein kann, weist senkrecht nach vorne ragende Verbindungslaschen 51 auf, welche im Wesentlichen umlaufend um die Rückwand 5 herum angeordnet sind (siehe Figuren 10 bis 12). Die Verbindungslaschen 51 dienen einerseits zur Befestigung der Rückwand 5 an der Innenseite des Rahmens 1 mittels Schraubverbindungen. Andererseits dienen die Verbindungslaschen 51 aber auch zur Herstellung einer wärmeleitenden Verbindung zwischen dem Rahmen 1 und der Rückwand 5. Im Flachbildschirm entstehende Wärmeenergie, welche von den Randleisten 7 auf den Rahmen 1 übertragen wird, kann dadurch via die Verbindungslaschen 51 weiter auf die Rückwand 5 geleitet werden. Auf der Aussenseite der Rückwand 5, aber auch auf der Aussenseite des Rahmens 1, können wärmeabstrahlende Elemente, wie zum Beispiel rippenähnliche Strukturen, angebracht sein, welche die Wärmeenergie in die Umgebung abstrahlen. Bei der vorliegenden Ausführungsform sind aber keine derartigen wärmeabstrahlenden Elemente vorgesehen, da die Rückwand 5 bereits eine genügend grosse Fläche bildet, um die im Flachbildschirm entstehende Wärmeenergie nach aussen hin abzustrahlen.

Die Rückwand 5 wird bevorzugt derart am Rahmen 1 angeschraubt, dass ein im Innern des Gehäuses aufgenommener Flachbildschirm fest zwischen den wärmeabführenden Leisten 7 und der Rückwand 5 gehalten und insbesondere dazwischen eingeklemmt ist. Eine optimale Wärmeübertragung vom Flachbildschirm auf das Gehäuse kann dadurch sichergestellt werden. Indem für die Verbindungen zwischen den Verbindungslaschen 51 und dem Rahmen 1 Schraube-Mutter-Verbindungen vorgesehen werden, und zudem die entsprechenden Verbindungsbohrungen 12 derart ausgebildet werden, dass die Schraube vor dem Anziehen der jeweiligen Schraubverbindung ein gewisses Spiel in der Verbindungsbohrung 12 hat, kann ein enges Anliegen der Rückwand 5 an der Hinterseite des Flachbildschirms auch bei herstellungsbedingten Toleranzen gewährleistet werden.

Bei der Herstellung des Gehäuses wird die Frontscheibe 4 bevorzugt auf die nach vorne hin gerichteten Flächen der wärmeabführenden Leisten 7 aufgelegt und insbesondere daran angeklebt. In den Figuren 10 bis 12 ist eine in Bezug auf die Anordnung der Frontscheibe 4 alternative, weniger bevorzugte Ausführungsform gezeigt, bei welcher die Frontscheibe 4 anstatt an den nach vorne hin gerichteten Flächen an den nach hinten hin gerichteten Flächen der wärmeabführenden Leisten 7 angeklebt ist. Die Frontscheibe 4 ist in dieser alternativen Ausführungsform somit zwischen den wärmeabführenden Leisten 7 und dem Flachbildschirm angeordnet. Bevorzugt ist jedoch eine Anordnung, bei welcher die wärmeabführenden Leisten 7, anders als in den Figuren gezeigt, zwischen der Frontscheibe 4 und dem Flachbildschirm angeordnet sind.

Selbstverständlich ist die hier beschriebene Erfindung nicht auf die erwähnte Ausführungsform beschränkt und eine Vielzahl von Abwandlungen ist möglich. So stellen insbesondere die Herstellung des Rahmens 1 aus einem Flachprofilelement mit mehreren Sollbiegestellen einerseits, sowie das Vorsehen einer Innenrille 18 am Rahmen 1 zum Einsetzen von den wärmeabführenden Elementen 7 andererseits, zwei voneinander unabhängige Erfindungen dar. Es ist durchaus denkbar, ein Gehäuse mit einem Rahmen vorzusehen, der aus einem Flachprofilelement mit mehreren Sollbiegestellen hergestellt ist, aber keine Innenrille für wärmeabführende Elemente aufweist. Die Wärme kann dann auf eine andere, dem Fachmann bekannte Art und Weise abgeführt werden. Genauso ist umgekehrt ein Gehäuse mit einem Rahmen denkbar, der auf seiner Innenseite eine Innenrille für wärmeabführende Elemente aufweist, aber nicht aus einem Flachprofilelement, sondern zum Beispiel aus Guss-Aluminium hergestellt ist. Falls wärmeabführende Leisten vorhanden sind, müssen diese nicht zwingend umlaufend vorgesehen sein. Es ist insbesondere auch ein Gehäuse mit einem Rahmen vorstellbar, welcher zum Beispiel nur entlang seiner oberen Seite eine wärmeabführende Leiste aufweist. Die wärmeabführenden Elemente müssen zudem nicht einmal zwingend als Leisten ausgestaltet sein, sondern können als beliebige von der Innenseite des Rahmens in den Gehäuseinnenraum 8 ragende Vorsprünge, die zum Anliegen an den Flachbildschirm geeignet sind, ausgestaltet sein. Der Rahmen muss zudem nicht zwingend derart ausgestaltet sein, dass er in Umfangsrichtung vollständig geschlossen ist. Die beiden Enden des Flachprofilelements können beim fertig gebogenen Rahmen durchaus auch beabstandet zueinander angeordnet sein, und es ist nicht unbedingt notwendig, dass sie über eine Verbindungsplatte miteinander verbunden sind.

Selbstverständlich können die Frontblende 2, der Rahmen 1, die Verbindungsplatte 3, die wärmeabführenden Leisten 7, die Rückwand 5 und das Steuerschaltungsmodul 6 auf beliebige, dem Fachmann bekannte Art und Weise miteinander verbunden sein. Vorstellbar sind hierzu insbesondere Schraub-, Niet- oder Klebverbindungen. Weiter müssen die Sollbiegestellen nicht zwingend als eingefräste Nuten ausgebildet sein, sondern können durch beliebige Materialverdünnungen an den entsprechenden Stellen, beispielsweise hergestellt mittels walzen, pressen, etc., ausgebildet sein. Auch Sollbiegestellen basierend auf Perforationen an den entsprechenden Stellen des Flachprofilelements sind möglich.

In einer alternativen Ausführungsform können zudem an der Innenfläche der Rückwand 5 weitere wärmeabführenden Elemente angebracht sein, welche zum Anliegen an die Rückwand des Flachbildschirms vorgesehen sind. Diese wärmeabführenden Elemente können insbesondere derart ausgestaltet sein, dass sie aufgrund ihrer Form zumindest geringfügig in eine senkrecht zur Innenfläche der Rückwand stehende Richtung elastisch komprimierbar sind. Die wärmeabführenden Elemente sind dann also ähnlich wie eine Feder zwischen den beiden Oberflächen der Rückwand und des Flachbildschirms eingespannt. Eine derartige Form dieser zusätzlichen wärmeabführenden Elemente kann beispielsweise dadurch erreicht werden, dass sie insgesamt eine Z- oder S-förmige Gestalt aufweisen. Die Komprimierbarkeit stellt sicher, dass diese wärmeabführenden Elemente auch unter Berücksichtigung von fertigungstechnischen Toleranzen jederzeit an dem im Gehäuse aufgenommenen Flachbildschirm anliegen und dadurch die entstehende Wärme zur Rückwand und somit nach aussen hin ableiten.

Eine Vielzahl weiterer Abwandlungen ist denkbar.

### BEZUGSZEICHENLISTE

- 1: Rahmen
- 10: Sichtbohrung
- 11: Aussparung
- 12: Verbindungsbohrung
- 13: Verbindungsstelle
- 14: Einkerbung
- 15: Nut
- 16: Plane Fläche
- 17: Gebogene Fläche
- 18: Innenrille
- 19: Eckbereich
- 2: Frontblende

- 21: Verbindungslasche
- 22: Bohrung
- 23: Aussparung
- 3: Verbindungsplatte
- 31: Bohrung
- 4: Frontscheibe
- 5: Rückwand
- 51: Verbindungslasche
- 6: Steuerschaltungsmodul
- 61: Anschlüsse
- 7: Wärmeabführende Leiste
- 8: Gehäuseinnenraum

## Patentansprüche

1. Gehäuse zur Aufnahme eines Flachbildschirms, mit einem Rahmen (1), welcher einen Gehäuseinnenraum (8) zur Aufnahme des Flachbildschirms begrenzt,
**dadurch gekennzeichnet, dass**
der Rahmen (1) aus einem Flachprofilelement hergestellt ist, welches mehrere Sollbiegestellen (15) aufweist, die zur Festlegung der Eckbereiche (19) des Rahmens (1) dienen.

2. Gehäuse nach Anspruch 1, wobei die Sollbiegestellen (15) jeweils durch eine Materialverdünnung an der entsprechenden Stelle definiert sind.

3. Gehäuse nach Anspruch 2, wobei die Materialverdünnungen jeweils durch eine Nut (15) gebildet sind, welche von zwei planen Flächen (16) und einer dazwischen angeordneten, gebogenen Fläche (17) begrenzt ist.

4. Gehäuse nach Anspruch 3, wobei die beiden planen Flächen (16) einen Winkel von mehr als 80° und weniger als 100°, insbesondere von ungefähr 90°, einschliessen.

5. Gehäuse nach einem der vorhergehenden Ansprüche, wobei der Rahmen (1) auf seiner zum Gehäuseinnenraum (8) hin gewandten Seite eine Innenrille (18) aufweist, und wobei das Gehäuse zumindest ein wärmeabführendes Element (7) aufweist, welches in die Innenrille (18) des Rahmens (1) eingesetzt ist, und welches zum Übertragen von Wärme, die im Gehäuseinnenraum (8) entsteht, auf den Rahmen (1) dient.

6. Gehäuse nach einem der vorhergehenden Ansprüche, wobei der Rahmen (1) eine Verbindungsstelle (13) aufweist, bei welcher die beiden Enden des Flachprofilelements miteinander verbunden sind.

7. Gehäuse nach einem der vorhergehenden Ansprüche, wobei der Rahmen (1) eine Aussparung (11) aufweist, welche zur Aufnahme eines Elektronik-Bauteils dient.

8. Gehäuse nach einem der vorhergehenden Ansprüche, wobei das Gehäuse eine Rückwand (5) aufweist, an welcher zumindest eine Verbindungslasche (51) angebracht ist, die zur Verbindung der Rückwand (5) mit dem Rahmen (1) dient.

9. Gehäuse insbesondere nach einem der vorhergehenden Ansprüche, zur Aufnahme eines Flachbildschirms, aufweisend einen Rahmen (1), welcher einen Gehäuseinnenraum (8) zur Aufnahme des Flachbildschirms begrenzt, sowie zumindest ein wärmeabführendes Element (7), welches an der Innenseite des Rahmens (1) angebracht ist, und welches zum Übertragen von Wärme, die im Gehäuseinnenraum (8) entsteht, auf den Rahmen (1) dient,
**dadurch gekennzeichnet, dass**
der Rahmen (1) auf seiner zum Gehäuseinnenraum (8) hin gewandten Seite eine Innenrille (18) aufweist, in welche das wärmeabführende Element (7) eingesetzt ist.

10. Gehäuse nach Anspruch 9, wobei das wärmeabführende Element eine Leiste (7) ist.

11. Gehäuse nach einem der Ansprüche 9 und 10, wobei das Gehäuse eine Frontscheibe (4) aufweist, welche am wärmeabführenden Element (7) angeklebt ist.

12. Verfahren zur Herstellung eines Gehäuses nach einem der vorhergehenden Ansprüche zur Aufnahme eines Flachbildschirms, mit einem Rahmen (1), welcher einen Gehäuseinnenraum (8) zur Aufnahme des Flachbildschirms begrenzt,
**dadurch gekennzeichnet, dass** bei einem Flachprofilelement mehrere Sollbiegestellen (15) vorgesehen werden, und dass das Flachprofilelement anschliessend in den Bereichen dieser Sollbiegestellen (15) derart gebogen wird, dass jeweils ein Eckbereich (19) des Rahmens (1) geformt wird.

13. Verfahren nach Anspruch 12, wobei am Flachprofilelement eine Innenrille (18) vorgesehen wird, welche derart angeordnet ist, dass sie sich einerseits in Längsrichtung des Flachprofilelements erstreckt, und dass sie sich andererseits nach dem Biegen des Flachprofilelements auf der Innenseite des Rahmens (11) befindet.

14. Verfahren nach einem der Ansprüche 12 oder 13, wobei die Sollbiegestellen (15) mittels eines spanabhebenden Prozesses, wie insbesondere Einfräsen, hergestellt werden.

15. Vorrichtung aufweisend ein Gehäuse nach einem der Ansprüche 1 bis 11 sowie einen im Gehäuse aufgenommenen Flachbildschirm.
